# EUROPEAN PATENT APPLICATION

(11) **EP 0 619 364 A1**
(43) Date of publication of application: **12.10.1994**
(21) Application number: 94200955.6
(22) Date of filing: 08.04.1994
(51) Int. Cl.: C11D 3/20, C11D 7/26, C23G 5/032

(54) **A non-ozone depleting cleaning composition for degreasing and defluxing purposes**

(30) Priority: 09.04.1993 JP 107284/93; 08.02.1994 EP 94200235
(71) Applicant: PURAC BIOCHEM N.V., NL-4200 AA Gorinchem (NL)
(72) Inventor: Maruyama, Akihiro, Higashikatsushika-gun, Chiba-Ken 277 (JP); Bergenstahl, Björn, SE-172 46 Sundbyberg (SE); Van de Hoek, Eric, NL-3362 NC Sliedrecht (NL)
(74) Representative: de Bruijn, Leendert C.

(57) **Abstract**

The invention relates to non-ozone depleting cleaning compositions for degreasing elements in manufacturing and engineering processes like oily machine parts and for defluxing printed circuit boards, used in the electric and electrical industry. The composition according to the invention contains at least one C₆₋₁₂ alkyllactate ester, preferably 2-ethylhexyl lactate, in an amount of 70-99% by weight and at least one emulsifier, preferably n-octanol, in an amount of 1-30% by weight. One of the main advantages of the present cleaning composition is based on the fact that in the rinsing step with water for removing the cleaning composition from the treated surface an emulsion is formed, which on the one hand is stable enough for having proper rinsing ability and on the other hand - after the rinsing step - will separate rather quickly into an oil and a water phase. This last mentioned phenomenon provides the benifits of reusing the active cleaning agent, i.e. the C₆₋₁₂ alkyllactate ester and reusing and/or partly discarding the waste water being toxicologically and environmentally safe.

## Description

The invention relates to non-ozone depleting cleaning compositions for the removal of grease or oil from elements in the manufacturing and engineering processes like oily machine parts and for defluxing of printed circuit boards within the assembly process.

Traditionally either ozone depleting or toxic cleaners are used which application is increasingly restricted due to their environmental impact. The Montreal protocol of the year 1989 covers the phase out of ozone depleting chemicals such as Freon solvents e.g. CFC 113 and chlorine type solvents e.g. 1,1,1-trichloroethane. For toxicity reasons also methylene chloride and trichloroethylene are being replaced. As a result of these phase out schedules the industry is searching for alternative cleaners and cleaning procedures.

In view of the above it is pointed at Japanese application 2-176176 having a filing date of July 5, 1990. More in particular said Japanese application is directed to a cleaning composition as substitute for Freons and chlorine type solvents, which composition contains as essential ingredients a non-ionic surfactant and one or more 1-monocarboxylic acid esters having the formula R₁-COO-R₂, wherein R₁ represents an alkyl group having 1-6 carbon atoms and R₂ represents an alkyl group having 1-10 carbon atoms with the proviso that the sum of the carbon atoms of the symbols R₁ and R₂ is at least 7.

The concentration of the non-ionic surfactant, used in the prior art cleaning composition is in the range of 1-30% by weight. Examples of the surfactants are the polyoxyethylene compounds such as the polyoxyethylene alkylethers etc.

Examples of the monocarboxylic acid esters being used in the range of 50-99% of the cleaning compositions are sec-hexyl acetate, 2-ethylhexyl acetate, isopentyl propionate, butyl butyrate and isopentyl isobutyrate.

Also various stabilisers and additives like hydrocarbons, alcohols, ethers, esters, acetals, ketones, fatty acids, nitroalkanes, amines, amides, glycols, aminoethanols and benzotriazoles can be added to the cleaning compositions in order to preserve the stability of the liquid, raise the stability in relation to the object to be cleaned or raising the dissolving capacity of the composition. Further also anionic surfactants can be added to these prior art compositions.

It is stated in said Japanese application 2-176176 that the compositions in question would have a good finish and a high degreasing capacity which matches those of prior cleaners for this purpose like Freons and chlorine type solvents. However, nothing is mentioned abut the reuse possibilities of the active cleaning agent in the cleaning composition as under the heading "Benefits of the invention" there is merely talk of the high biodegradability of the cleaning compositions by environmental microorganisms.

Following up the above it is pointed yet at the rather complicated composition of the cleaning embodiments 1-5 indicated in Table 4 of said Japanese Application 2-176176 and comprising at least five components.

In Japanese patent application 1-172051 filed on July 5, 1989 a cleaning agent for defluxing printed circuit boards is disclosed, which is characterized by the presence of an alkyllactate ester as its main component. Examples of such alkyllactate esters, which are advantageously used, are methyllactate, isopropyllactate, butyllactate and most preferably ethyllactate. Although the cleaning agent may be formed by only the above-mentioned alkyllactate esters or mixtures thereof the alkyllactate ester may also be mixed (up to 10%) with well-known solvents such as water, methanol, ethanol, isopropanol, nitromethane, nitroethane and N-methyl-2-pyrrolidone etc.. Therefore no mention is made of the possible use of compounds having a specific activity like an emulsier as a component of the cleaning agent according to said Japanese patent application 1-172051. Further no indication whatsoever is given for reusing the active cleaning compound after the cleaning stage of the printed circuit boards which would result in a better economy of the cleaning process and a smaller impact on the environment on account of the discard of a minimal amount of effluent of the process.

In view of the above Applicant has searched for alternatives, which (a) have an excellent cleaning ability in the above-mentioned field of degreasing and defluxing, (b) are non-ozone depleting and toxicologically and environmentally safe and (c) provide a cleaning process having a minimal impact on the environment.

Surprisingly it has been found by Applicant that a cleaning composition, comprising at least one C₆₋₁₂ alkyllactate ester as the main component and at least one emulsifier as the minor component do meet the above-mentioned requirements.

More in particular it is brought to the fore that the contaminated surfaces like greasy or oily surfaces or printed circuit boards are treated with the cleaning composition according to the invention by means of immersion or spraying. Above cleaning step may be supported by either heat or ultrasound. Subsequently the treated surfaces are rinsed with water to remove the cleaner from the surfaces. Due to the composition of the present cleaning composition an emulsion is formed on water rinsing, which is stable enough to have a proper rinsing ability. As is generally known the cleaning performance is adversely affected by a poor rinsability of the cleaning composition.

Further to the above indicated advantage of the cleaning composition according to the invention, i.e. the good rinsing ability with water, the emulsion collected after the rinsing step will easily and quickly separate into an oil and water phase, which are both easy to reuse. Therefore the second advantage of the cleaning composition according to the invention is lain in the reuse-possibilities of the C₆₋₁₂ alkyllactate ester as the main cleaning agent and the waste-water, which may partly be discarded from the cleaning process. Summarizing it is emphasized that by adjusting the composition of the invention to the polluted objects to be treated an optimum is created between (a) a proper water rinsability or cleanliness of the treated surface and (b) the reuse possibilities of both the cleaning agent, i.e. the C₆₋₁₂ alkyllactate ester, the emulsifier and the waste-water, resulting in a reduction of both cleaner consumption, waste- water volume and pollution of the environment.

Concerning the emulsion to be formed after rinsing the surface treated with cleaning composition with water it is brought to the fore that the stability of said emulsion should only be stable enough for achieving a proper rinsing stability, i.e. the emulsion obtained after the rinsing step should break into an oil and water phase as quickly as possible. The shorter the breaking time the sooner the cleaning agent, i.e. the C₆₋₁₂ alkyllactate ester and a part of the obtained waste-water can be recycled to the cleaning step.

Examples of C₆₋₁₂ alkyllactate esters, that can be used for degreasing greasy or oily elements or for defluxing printed circuit boards are n-hexyllactate, octyllactate, nonyllactate, decyllactate and preferably 2-ethylhexyllactate.

With regard to the emulsifier it is preferably pointed at non-ionic surfactants. Examples of non-ionic surfactants include polyoxyethylene derivatives such as polyoxyethylene alkyl ethers like polyoxyethylene lauryl ethers, polyoxyethylene cetyl ethers, polyoxyethylene stearyl ethers and polyoxyethylene oleyl ethers, etc., polyoxypropylene ethers, polyoxyethylene alkylphenyl ethers like polyoxyethylene nonylphenyl ethers and polyoxyethylene octylphenyl ethers, etc., polyoxyethylene/polyoxypropylene block copolymers, polyoxyethylene sorbitan fatty acid esters, polyoxyethylene fatty acid esters, polyoxyethylene alkyl amines and polyoxyethylene fatty acid amides, etc., polyoxypropylene ethers, sorbitan fatty acid esters and glycerol fatty acid esters, etc. These surfactants can be used singly or in a combination of two or more. The number of added molecules in the ethylene oxide part of the polyoxyethylene type non-ionic surfactant is advantageously 3-40.

The preferred non-ionic surfactants are alkanols having 6-12 carbon atoms. The most preferred alkanol is n-octanol.

With regard to the components of the composition of the invention it is remarked that the C₆₋₁₂ alkyllactate ester is advantageously present in an amount of 70-99% by weight and the emulsifier in an amount of 1-30% by weight, based on the whole composition.

The invention is illustrated with the help of a number of examples; the indicated percentages are percentages by weight, calculated on the whole composition.

### Example 1

This example relates to degreasing tests with flat carbon steel coupons (size: 50x20 mm) loaded by a roller with 75 µm of a press forming oil (Firm: BP) and baked at 120°C for 18 hours. The obtained contaminated carbon steel coupons were cleaned at room temperature by immersion of said coupons in the cleaning liquid shown in Table A present in a beakerglas and circulation of the liquid through oscillation of the beakerglas at a frequency of 90/min. and an applitude of 4.5 cm. The immersion time is 30 sec. The immersion cleaning is followed by spray rinsing with water for 30 sec. with a mobile oscillating spray head at a spray pressure of 0.5 bar.

The cleanliness-level of the surface of the coupons after cleaning is measured through ATR-FTIR (Attenuated Total Reflection-Fourier Transform InfraRed spectroscopy). More in particular the above FTIR-method relates to a method according to which the contamination left on the surface of the objects after cleaning is determined by reflection mode Fourier Transform Intrared spectroscopy. The spectra are collected on the metal surfaces directly. The cleanliness level of the surface is characterized by the area under the spectral lines in the wavelength-range of 2700-3000 cm⁻¹.

**TABLE A**

| Tests | Lactate ester | Emulsifier | FTIR |
|---|---|---|---|
| 1 | 2-Ethylhexyl lactate | 3% Tween 20* | 0.04 |
| 2 | 2-Ethylhexyl lactate | 2% octanol | 0.09 |
| 3 | Hexyl lactate | 3% Tween 20 | 0,17 |
| 4 | Octyl lactate | 3% Tween 20 | 0.16 |
| 5 (comparative) | Ethyllactate | none | 0.40 |
| 6 (comparative) | 2-Ethylhexyl lactate | none | 0.55 |
| 7 (comparative) | Water | none | 13.84 |

| | | | |
|---|---|---|---|
| * Tween 20: ethoxylated sorbitan monoester (Firm: ICI) | | | |

### Example 2

Contaminated carbon steel coupons obtained according to Example 1 are treated with the cleaning liquids shown in Table B in the way as indicated in Example 1.

The emulsification properties of the several emulsifiers are evaluated through measurement of the turbidity with a dispersion analyser (type PDA 2000). More in particular the cleaning liquid (5%) and water are mixed with a rotor. The emulsion thus formed is pumped through a dispersion analyser (PDA 2000) to measure "the turbidity" of the emulsion. With an efficient emulsifier, a large number of small cleaner droplets are dispersed in the water increasing the turbidity. The water rinsing properties are directly related to the turbidity of the emulsion.

The emulsion stability is classified in a scale from 1 to 5, wherein 1 represents an emulsion which is stable for a few days and 5 represents immediate separation of the emulsion.

The optimum is represented by a number 5 stability, combined with a high turbidity and a very low FTIR.

**TABLE B**

| Tests | Lactate ester | Emulsifier | FTIR | Turbidity | Stability |
|---|---|---|---|---|---|
| 8 | 2-Ethylhexyl lactate | 3% Berol* 07 | 0.06 | 42.5 | 3 |
| 9 | 2-Ethylhexyl lactate | 3% Na oleate | 0.22 | 22 | 4 |
| 10 | 2-Ethylhexyl lactate | 3% PEG** 10000 | | 5 | 5 |
| 11 | 2-Ethylhexyl lactate | 3% Octanol | 0.06 | | 5 |

| | | | | | |
|---|---|---|---|---|---|
| * Berol 07: ethoxylated alcohol (Firm: Berol Nobel) | | | | | |
| ** PEG : polyethylene glycol | | | | | |

### Example 3

A further series of tests are described to demonstrate the defluxing ability of the cleaning composition of the present invention. Test FR-4 laminate testboards are used, assembled with two 68-terminal 50 mil pitch J-leaded plastic chip carriers (PLCC68) and 12 chip capacitors type 2220 (CC2220). The chosen components are very to extremely difficult to clean due to their size and stand-off height. A Kester Rheomat 229 paste (Firm: Kester) is applied in a reflow soldering process.

The cleaning procedure with the cleaning liquids shown in Table C is performed at 60°C for 2 minutes after which the boards are rinsed first with tap water and secondly with deionized water. The drying process is a two-stage process i.e. the boards are first dried with pressurized nitrogen gas and then heated at 80°C for 2 minutes.

Cleanliness is evaluated through a "Protonique MCM-1 contamination test" of the ionic residues. More in particular the cleanliness level of the production boards is measured by a protonique unit. The remaining contamination after cleaning is expected to dissolve in a water/IPA mixture. Then the dissolved contamination is measured through conductivity and expressed in µg equivalent NaCl/cm² (see Table C).

Visual inspection is carried out and results are ranked from 1 (completely clean) to 5 (very contaminated) and shown in Table C.

**TABLE C**

| Tests | Ionic residues µg eq. NaCl/cm³ | | Visual inspection | |
|---|---|---|---|---|
| | CC2220 | PLC68 | CC2220 | PLC68 |
| Reference* | 0.288 | 0.425 | 5 | 5 |
| 2-Ethylhexyl lactate + 3% Tween 20 | 0.095 | 0.032 | 4 | 2 |
| 2-Ethylhexyl lactate + 3% Octanol | 0.050 | 0.025 | 1 | 1 |

| | | | | |
|---|---|---|---|---|
| * Reference is non-treated and non-cleaned. | | | | |

## Claims

1. A non-ozone depleting cleaning composition, characterized in that it contains
a) at least one C₆₋₁₂ alkyl lactate ester as the main component and
b) at least one emulsifier as the minor component.

2. The composition according to Claim 1, characterized in that said C₆₋₁₂ alkyllactate ester is 2-ethylhexyl lactate.

3. The composition according to Claims 1 or 2, characterized in that said emulsifier is a non-ionic surfactant.

4. The composition according to Claim 3, characterized in that said emulsifier is an alkanol.

5. The composition according to Claim 4, characterized in that said emulsifier is n-octanol.

6. The composition according to any of the Claims 1-5, characterized in that said C₆₋₁₂ alkyllactate ester is present in an amount of 70-99% by weight, based on the whole composition.

7. The composition according to any of the Claims 1-6, characterized in that said emulsifier is present in an amount of 1-30% by weight, based on the whole composition.

8. The composition according to Claims 1-7, characterized in that said C₆₋₁₂ alkyllactate ester is 2-ethylhexyl lactate and said emulsifier is n-octanol.
